# DEMANDE DE BREVET EUROPEEN

(11) **EP 2 568 507 A1**
(43) Date de publication de la demande: **13.03.2013**
(21) Numéro de dépôt: 12354043.7
(22) Date de dépôt: 11.09.2012
(51) Int. Cl.: H01L 29/739

(54) **Transistor à effet de champ Z2FET à pente sous le seuil verticale et sans ionisation par impact**

(30) Priorité: 12.09.2011 FR 1102747
(71) Demandeur: Commissariat à l'Énergie Atomique et aux Énergies Alternatives, 75015 Paris (FR); Centre National de la Recherche Scientifique (CNRS), 75794 Paris Cedex 16 (FR)
(72) Inventeur: Wang, Jing, 38000 Grenoble (FR); Cristoloveanu, Sorin, 38170 Seyssinet Pariset (FR); Le Royer, Cyrille, 38210 Tullins-Fures (FR); Zaslavsky, Alexander, 02906 Providence Rhode Island (US)
(74) Mandataire: Talbot, Alexandre

(57) **Abrégé**

Le transistor comporte des première et deuxième électrodes source/drain (2, 3) formées dans un film semi-conducteur (4) par des zones dopées respectivement N et P. Une polarisation est appliquée entre les deux électrodes source/drain (2, 3) pour imposer sur l'électrode dopée de type P un potentiel supérieur à celui de l'électrode dopée de type N. Le transistor comporte des premier et deuxième dispositifs de génération de barrière de potentiel (Q, R) dans le film semi-conducteur (4). Les deux barrières de potentiel (Q, R) s'opposent au passage des porteurs de charge émis respectivement par les première et deuxième électrodes source/drain (2, 3). Les deux barrières de potentiel (Q, R) sont décalées selon un axe (X) reliant les deux électrodes source/drain (2, 3). Les deux dispositifs de génération de barrière de potentiel sont configurés pour générer une barrière de potentiel à amplitude modulable et sont reliés électriquement à la grille (1) et à une contre-électrode (12).

## Description

### Domaine technique de l'invention

L'invention est relative à un transistor à effet de champ.

### État de la technique

Au fur et à mesure des évolutions technologiques, la densité d'intégration dans les circuits intégrés a augmenté de manière continue ce qui a permis d'incorporer un nombre toujours plus important de fonctions électroniques pour une surface donnée de silicium. Cependant, la puissance consommée par les circuits électroniques a également fortement augmenté et la puissance consommée par le circuit intégré est devenue un nouveau point de préoccupation pour les noeuds technologiques à venir, en particulier pour les applications mobiles. En plus de continuer l'augmentation de la densité d'intégration pour les futurs noeuds technologiques, il devient important de se concentrer sur les moyens de maitriser la puissance dissipée par le circuit.

La puissance dissipée dans le circuit comporte une composante dynamique qui provient du basculement des transistors entre leurs états passant et bloquant. La puissance dissipée comporte également une composante statique qui est liée aux fuites dans le transistor lorsqu'il se trouve à l'état bloquant. Avec la diminution continue des dimensions des transistors et des tensions d'alimentation, une partie importante de la consommation dynamique des transistors est due à la consommation par les fuites sous le seuil qui est un paramètre soumis à des considérations physiques ne pouvant être contournées ce qui fait que la valeur de la pente sous le seuil ne peut pas dépasser une valeur limite.

Il est alors un besoin de trouver des solutions qui permettent de réduire la dissipation de puissance dans un circuit électronique.

La publication de Alvaro Padilla et al. Décrit un dispositif muni d'une jonction de type PN associée à deux électrodes de grille montées adjacentes. Des charges électriques sont bloquées à l'intérieur d'espaceurs.

La publication de Manavizadel et al. décrit un dispositif muni d'une diode associées à deux électrodes de grilles montées adjacentes.

### Objet de l'invention

On constate qu'il existe un besoin de proposer un transistor à effet de champ compact dont la consommation est réduite. Pour cela, on cherche un transistor à effet de champ selon les revendications annexées.

### Description sommaire des dessins

D'autres avantages et caractéristiques ressortiront plus clairement de la description qui va suivre de modes particuliers de réalisation de l'invention donnés à titre d'exemples non limitatifs et représentés aux dessins annexés, dans lesquels :
- les figures 1 à 5 représentent, de manière schématique, en vue de coupe transversale, différents modes de réalisation d'un transistor à pente sous le seuil verticale,
- les figures 6 et 7 représentent, de manière schématique, les diagrammes de bande d'un transistor soumis à différentes polarisations et, le courant circulant dans le transistor en fonction de la polarisation de l'électrode de grille.

### Description d'un mode préférentiel de l'invention

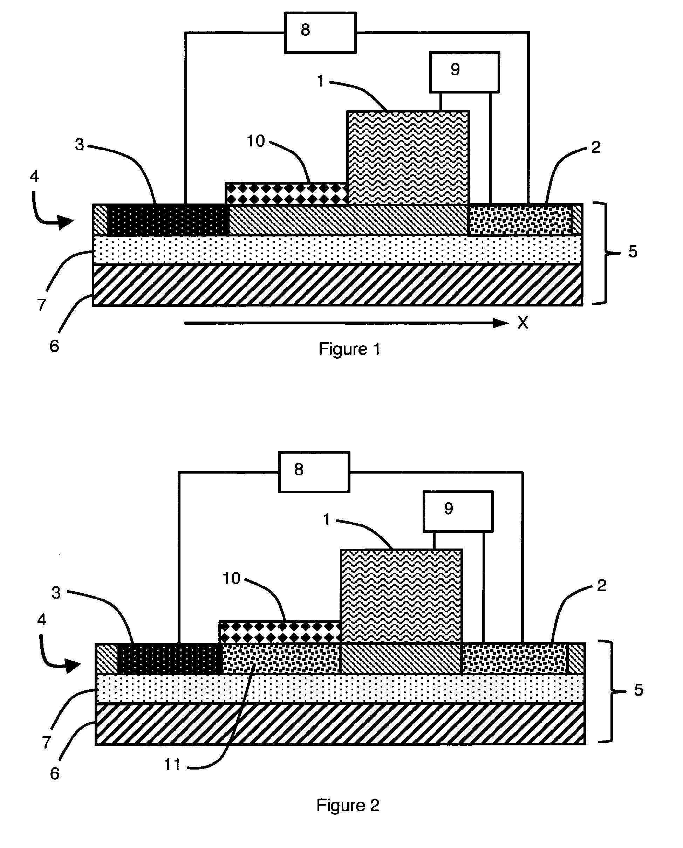

Comme illustré à la figure 1, le transistor comporte une électrode de grille 1, une première électrode de source/drain 2 et une deuxième électrode de source/drain 3. Le transistor est réalisé sur un film semi-conducteur 4, de manière préférentielle sur un substrat de type semi-conducteur sur isolant 5 qui comporte un substrat de support 6, une couche électriquement isolante 7 et le film semi-conducteur 4. Le substrat de support 6 est séparé du film semi-conducteur 4 par la couche électriquement isolante 7.

L'électrode de grille 1 est séparée du film semi-conducteur 4 par un matériau diélectrique de grille (non représenté) qui est un matériau électriquement isolant. L'électrode de grille 1 est formée par un matériau électriquement conducteur qui permet un effet électrostatique sur le film semi-conducteur 4. Les première et deuxième électrodes de source/drain 2 et 3 sont formées dans le film semi-conducteur 4 et elles sont séparées par une zone inter-électrode du film semi-conducteur 4.

La zone inter-électrode est une zone du film 4 qui présente, avantageusement, au moins une portion avec un dopage plus faible que les dopages des électrodes de source/drain 2 et 3. La zone inter-électrode est, de préférence, une zone non-intentionnellement dopée (nid), par exemple un volume du film 4 avec un dopage de type p ou n de l'ordre de 10¹⁴ at/cm³. En variante, il est également possible d'avoir une zone inter-électrode plus dopée, par exemple avec des dopages de l'ordre de 10¹⁶ ou 10¹⁷ at/cm³.

Dans un mode de réalisation particulier illustré à la figure 1, la zone inter-électrode est une zone faiblement dopée avec un dopage uniforme depuis la première électrode 2 jusqu'à la deuxième électrode 3. Ce mode de réalisation permet l'obtention d'une bonne mobilité dans le canal de conduction qui relie les deux électrodes de source/drain 2 et 3.

Dans le film semi-conducteur 4, les électrodes de source et de drain sont séparées par un canal de conduction qui est disposé directement en dessous de l'électrode de grille 1. Le film 4 est avantageusement monocristallin pour assurer de bonnes performances électriques.

Dans certains modes de réalisation où le transistor est réalisé avec d'autres dispositifs actifs sur le film semi-conducteur 4, le transistor est isolé électriquement du reste du substrat au moyen d'un motif d'isolation (non représenté). Le motif d'isolation est réalisé dans un matériau électriquement isolant qui entoure le transistor. Le motif d'isolation s'enfonce dans le film semi-conducteur 4. Il peut également s'enfoncer dans la couche électriquement isolante 7 et dans le substrat de support 6.

La première électrode 2 de source/drain est formée dans le film semi-conducteur 4 par une première zone dopée d'un premier type de conductivité. La deuxième électrode 3 de source/drain est formée dans le film semi-conducteur 4 par une deuxième zone dopée d'un deuxième type de conductivité opposé au premier type de conductivité. Les deux électrodes de source/drain sont formées dans le film semi-conducteur 4 et elles sont décalées l'une par rapport à l'autre afin d'être séparées par la zone inter-électrode. La première électrode de source/drain 2 est, par exemple, dopée de type N et la deuxième électrode de source/drain est dopée de type P. La configuration inverse est également possible.

De manière générale, il y a donc une électrode de source/drain dopée de type N et une autre électrode de source/drain dopée de type P. A titre d'exemple, dans une couche semiconductrice du groupe IV, par exemple en silicium, en germanium ou dans un alliage de silicium-germanium, le dopage de type N est obtenu par incorporation d'arsenic ou de phosphore. Le dopage de type P est obtenu, par exemple, par incorporation de bore ou d'indium. D'autres matériaux semi-conducteurs sont envisageables comme des matériaux dits III-V ou II-VI.

Dans le transistor, il existe schématiquement une diode de type PN qui est formée par les deux électrodes de source/drain qui sont deux électrodes dopées de manières opposées. Comme la première électrode de source/drain 2 n'est pas en contact direct avec la deuxième électrode de source/drain 3, la structure n'est pas exactement celle d'une diode PN. Si la zone inter-électrode n'est pas dopée ou n'est pas intentionnellement dopée, la structure de la diode peut être assimilée à une diode de type PIN disposée dans le film semi-conducteur 4. La diode PIN est formée par les deux électrodes de source/drain 2 et 3 et par la zone inter-électrode. Si la zone inter-électrode est dopée, une structure un peu plus complexe est obtenue. La zone inter-électrode est en partie recouverte par l'électrode de grille 1.

Le transistor à effet de champ comporte également un circuit de polarisation 8 de la première électrode 2 de source/drain par rapport à la deuxième l'électrode de source/drain 3 pour appliquer une première différence de potentiel entre les deux électrodes de source/drain. Le circuit de polarisation 8 est configuré de manière à polariser en direct la diode définie par les deux électrodes de source/drain, c'est-à-dire que le dispositif comporte des moyens d'application d'un potentiel plus important sur l'électrode dopée de type P que sur l'électrode dopée de type N.

En d'autre terme le circuit de polarisation 8 est configuré de manière à ce que le potentiel appliqué sur l'électrode dopée de type P soit supérieur au potentiel appliqué sur l'électrode de type N.

La polarisation appliquée sur les deux électrodes de source/drain a pour effet de réduire l'amplitude de la barrière de potentiel qui existe dans les bandes de valence et de conduction (en l'absence de polarisation) ce qui se traduit également par l'apparition d'un courant de porteurs de charges entre les deux électrodes de source/drain.

Le dispositif peut fonctionner par enrichissement ou par déplétion. Par soucis de clarté un seul mode de fonctionnement est décrit mais l'homme du métier aura à l'esprit que le dispositif peut être transformé pour mettre en oeuvre l'autre mode de fonctionnement.

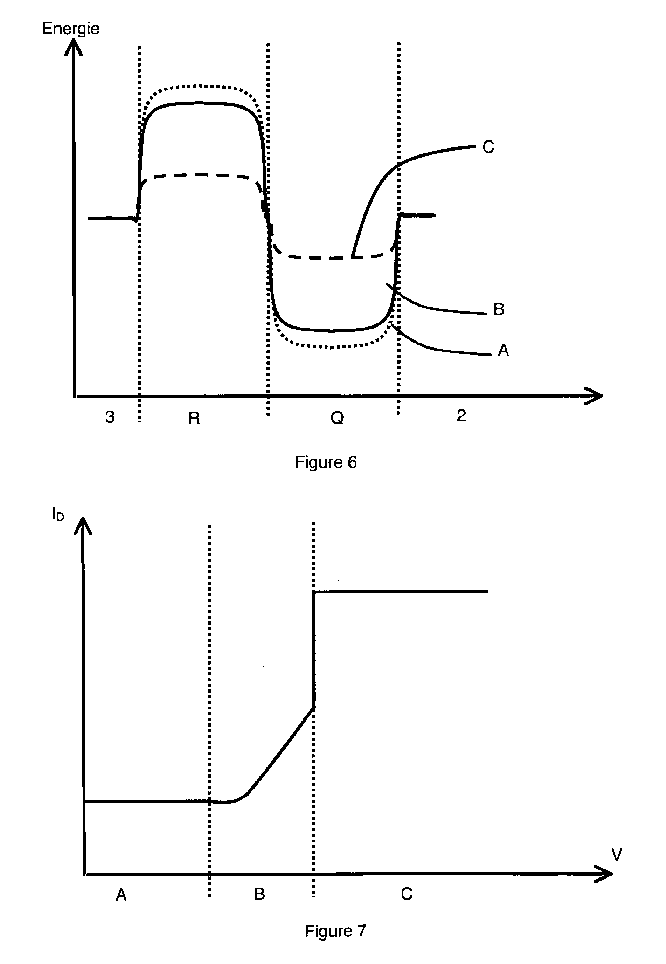

Le transistor à effet de champ comporte un premier dispositif de génération d'une première barrière de potentiel Q dans le film semi-conducteur 4 et un deuxième dispositif de génération d'une deuxième barrière de potentiel R dans le film semi-conducteur 4 (figure 6). Les première et deuxième barrières de potentiel sont décalées latéralement l'une de l'autre, c'est-à-dire qu'elles sont disposées en série dans une direction X qui relie la première électrode 2 de source/drain à la deuxième électrode 3 de source/drain. La première barrière de potentiel Q est disposée adjacente à la première électrode 2 de source/drain et la deuxième barrière de potentiel R est disposée adjacente à la deuxième électrode 3 de source/drain. De cette manière, la deuxième barrière de potentiel R est séparée de la première électrode 2 par la première barrière de potentiel Q et la première barrière de potentiel Q est séparée de la deuxième électrode 3 par la deuxième barrière de potentiel R selon l'axe X qui relie les deux électrodes de source/drain.

La première barrière de potentiel Q est configurée pour s'opposer au passage des charges électriques émises par la première électrode 2 de source/drain en direction de la deuxième électrode 3. La deuxième barrière de potentiel R est configurée pour s'opposer au passage des charges électriques émises par la deuxième électrode 3 de source/drain en direction de la première électrode 2. Une barrière de potentiel représente un minimum ou un maximum local de l'énergie dans la bande de conduction ou dans la bande de valence.

De cette manière, si la première électrode 2 est dopée de type N, la première barrière de potentiel Q dans la bande de conduction s'oppose au passage des électrons émis par l'électrode 2 en direction de la deuxième électrode 3 et la deuxième barrière de potentiel R dans la bande de valence s'oppose au passage des trous d'électrons émis par la deuxième électrode 3 en direction de la première électrode 2.

Dans le cas où la première électrode 2 est dopée de type P, la première barrière de potentiel Q dans la bande de valence s'oppose au passage des trous d'électrons émis par l'électrode 2 en direction de la deuxième électrode 3 et la deuxième barrière de potentiel R, de la bande de conduction s'oppose au passage des électrons émis par la deuxième électrode 3 en direction de la première électrode 2.

Le premier dispositif de génération et/ou le deuxième dispositif de génération comportent un circuit de polarisation à amplitude variable. De cette manière, l'amplitude de la première barrière de potentiel et/ou de la deuxième barrière de potentiel peuvent être modulées en fonction de la consigne appliquée par le circuit de polarisation associé. Cette modulation d'une des barrières de potentiel permet de définir la quantité de courant qui transite à l'intérieur du transistor et donc de définir un état passant et un état bloqué.

Les première et deuxième barrières de potentiel peuvent être obtenues au moyen de différentes techniques, par exemple au moyen de différents dispositifs de commande électrostatique qui sont disposés face à la zone inter-électrode, c'est-à-dire pour recouvrir au moins partiellement la zone inter-électrode dans l'axe X reliant les deux électrodes 2 et 3.

Dans un mode de réalisation préférentiel illustré à la figure 1, le dispositif de génération de la première barrière Q comporte un circuit de polarisation 9 de l'électrode de grille 1. Le circuit de polarisation 9 de l'électrode de grille 1 est alors configuré de manière à générer, face à l'électrode de grille 1, la première barrière de potentiel Q. Cette barrière de potentiel tend à s'opposer au passage des porteurs de charges émis par l'électrode de source/drain la plus proche. De cette manière, la répartition des potentiels dans le film semi-conducteur 4 tend à réduire la probabilité qu'une charge électrique transite entre les électrodes de source et de drain. Il est également possible, dans une configuration inverse, de considérer que le circuit de polarisation 9 de l'électrode de grille 1 est configuré de manière à générer, face à l'électrode de grille, la deuxième barrière de potentiel R, ce qui a été dit pour la première barrière peut être appliqué à la deuxième barrière et inversement.

Ainsi, lorsque l'électrode de grille 1 est localisée adjacente à la première électrode 2 de source/drain, c'est-à-dire lorsque l'électrode de grille 1 est plus proche de la première électrode 2 que de la deuxième électrode 3, deux cas de figure sont possibles. Le circuit de polarisation 9 de l'électrode de grille 1 est configuré de manière à ce que le potentiel de l'électrode de grille 1 soit inférieur au potentiel de la première électrode 2 lorsque la première électrode est dopée de type P. Le circuit de polarisation 9 de l'électrode de grille 1 est configuré de manière à ce que le potentiel de l'électrode de grille 1 soit supérieur au potentiel de la première électrode 2 lorsque la première électrode 2 est dopée de type N.

Dans le reste de la description, l'électrode de grille 1 est considérée adjacente à la première électrode 2 comme cela est représenté sur les différentes figures, mais il est également possible d'avoir l'électrode de grille 1 adjacente à la deuxième électrode 3 ce qui entraine un basculement de position des différents éléments décrits.

Dans ce mode de réalisation, l'autre barrière de potentiel (ici, la deuxième barrière de potentiel) peut être définie préférentiellement avec des moyens de commande appliquant une polarisation sur le substrat 6 (figure 1), par exemple constante. L'autre barrière de potentiel peut également être définie au moyen de la modulation des propriétés des bandes énergies par des charges électriques fixes disposées à proximité du film semi-conducteur ou au moyen de la modulation des propriétés des bandes d'énergies dans la zone inter-électrode.

Dans un mode de réalisation particulier illustré à la figure 1, l'autre barrière de potentiel provient de charges électriques présentes à l'interface entre le film semi-conducteur 4 et un film isolant de recouvrement 10 ou présenter dans le film électriquement isolant 10. Le film isolant de recouvrement 10 recouvre au moins partiellement la zone située entre l'électrode de grille 1 et la deuxième électrode 3. Ce matériau électriquement isolant comporte des charges électriques emprisonnées tout en restant électriquement isolant. Il est encore possible de placer des liaisons chimiques pendantes à l'interface avec le film 4 de manière à générer des charges électriques. Le procédé de réalisation de dépôt choisi permet de moduler la quantité de charges électriques présentes à l'interface. Par exemple, il est possible de déposer un oxyde de silicium comportant des charges électriques positives au moyen d'un dépôt chimique en phase vapeur. Dans ce cas, il y a deux dispositifs de modulation du niveau des bandes d'énergie dans le film semi-conducteur 4 par effet électrostatique. Ces deux commandes électrostatiques sont faces à la zone inter-électrode et elles sont décalées, selon l'axe X, l'une par rapport à l'autre pour générer deux barrières de potentiel distinctes. Une des commandes électrostatiques est variable en amplitude, l'électrode de grille 1. L'autre commande électrostatique est constante comme cela peut être le cas avec les charges électriques associées au film de recouvrement 10. L'autre commande électrostatique ne nécessite pas d'apport de courant ce qui est avantageux pour la consommation électrique du dispositif. Les deux commandes électrostatiques sont du même côté du film 4.

Dans une variante du mode de réalisation précédent et illustré à la figure 2, la deuxième barrière de potentiel est introduite en partie au moyen d'une zone dopée additionnelle 11 localisée sous le film de recouvrement entre les deux électrodes de source/drain 2 et 3 dans le film semi-conducteur 4. La zone dopée additionnelle 11 est disposée à proximité de l'électrode de source ou de l'électrode de drain et son type de dopage est choisi de manière à former une jonction de type PN avec l'électrode la plus proche. Ainsi, la zone additionnelle 11 est de type N si elle est placée à proximité de l'électrode dopée de type P. Au contraire, la zone additionnelle 11 est de type P si elle est placée à proximité de l'électrode dopée de type N. L'utilisation de la zone dopée 11 permet de réduire la variabilité de la valeur de la barrière en utilisant un matériau dont le positionnement des bandes de valence et de conduction sont connues. Utiliser la zone 11 permet également de s'affranchir d'une source de polarisation pour former la deuxième barrière de potentiel.

De manière générale, la zone dopée 11 comporte un dopage de type opposé à celui de son électrode la plus proche de manière à former une jonction PN dans le même sens que la jonction PN formée par la première électrode 2 et la deuxième électrode 3. La structure du film semi-conducteur peut être en partant de l'électrode 2 pour arriver à l'électrode 3, de type PIPN, NINP.

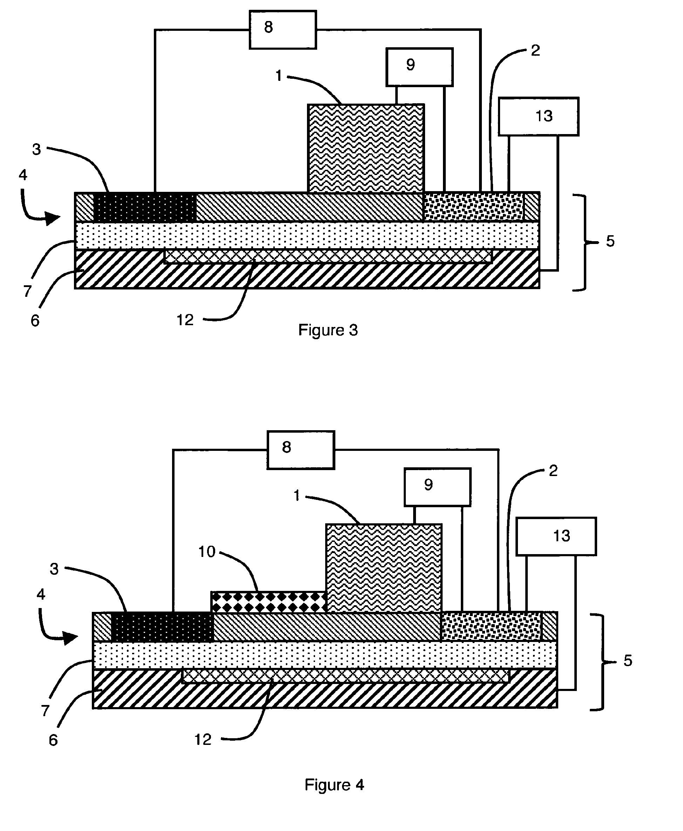

Dans un autre mode de réalisation préférentiel illustré à la figure 3 qui peut être combiné avec les modes de réalisation précédents, le substrat comportant le dispositif à effet de champ est un substrat de type semi-conducteur sur isolant 5 avec une contre-électrode 12. La contre-électrode 12 est séparée du film semi-conducteur 4 par la couche électriquement isolante 7. La contre-électrode 12 fait face à au moins une partie de la zone inter-électrode. La contre-électrode 12 peut également faire face à au moins une partie de l'électrode de grille 1. Le dispositif comporte alors un circuit de polarisation 13 de la contre-électrode 12 qui est configuré de manière à créer une différence de potentiel entre la première électrode 2 et la contre-électrode 12 qui est de même signe que la différence de potentiel existante entre la première électrode 2 et l'électrode de grille 1 que la première électrode 2 soit dopée P ou N. De manière préférentielle, la surface de recouvrement entre contre-électrode 12 et l'électrode de grille 1 est réduite afin de faciliter la formation et la commande des deux barrières de potentiel. De manière encore plus préférentielle, le dispositif est dépourvu de recouvrement entre l'électrode de grille 1 et la contre-électrode 12.

L'utilisation d'une contre-électrode 12 permet d'obtenir un dispositif compact car le décalage entre l'électrode de grille 1 et la contre-électrode 12 peut être faible voire nul et les interactions électrostatiques entre les électrodes sont réduites.

En d'autres termes, le circuit de polarisation 13 de la contre-électrode 12 est configuré pour présenter une différence de potentiel entre l'électrode dopée de type N et la contre-électrode 12 qui est de même signe que la différence de potentiel entre l'électrode dopée de type N et l'électrode de grille 1 lorsque l'électrode de grille 1 est localisée du côté N. Le circuit de polarisation 13 de la contre-électrode 12 est configuré pour présenter une différence de potentiel entre l'électrode dopée de type P et la contre-électrode 12 qui est de même signe que la différence de potentiel entre l'électrode dopée de type P et l'électrode de grille 1 lorsque l'électrode de grille 1 est localisée du côté P.

Le circuit de polarisation 13 peut être connecté directement à la contre-électrode 12 ou, par exemple, la connexion peut être réalisée au moyen du substrat 6.

La contre-électrode 12 peut être face à l'électrode de grille 1. Il existe une différence de dimension entre les deux électrodes 1 et 12 selon l'axe X de manière à pouvoir générer deux barrières de potentiel qui sont décalées selon l'axe X et qui sont orientées dans des directions opposées de potentiel.

La contre-électrode 12 peut encore être décalée par rapport à la première électrode de grille 1 afin de réduire, voire d'éviter un recouvrement des forces électrostatiques appliquées.

La contre-électrode 12 est avantageusement soumise à une polarisation constante.

Dans une variante de réalisation, la contre-électrode 12 peut être remplacée par un deuxième film de recouvrement. Le deuxième film de recouvrement peut être séparé du film 4 par la couche électriquement isolante 7. Le deuxième film de recouvrement peut également être formé dans la couche électriquement isolante.

Dans une autre variante de réalisation qui peut être combinée à la précédente, la contre-électrode 12 peut être remplacée par une zone dopée du substrat de support 6. Le type de dopant et le niveau de dopage sont configurés de manière à générer la deuxième barrière de potentiel. Le dopage du substrat 6 et/ou de la contre-électrode 12 permet de modifier la tension de bande plate (Flat-band en anglais) à l'interface entre le film semi-conducteur 4 et la couche électriquement isolante 7 de sorte que la deuxième barrière de potentiel peut être créée intrinsèquement sans utilisation de la contre-électrode 12 ou d'une polarisation non-nulle sur le substrat 6.

A titre d'exemple, la figure 4 illustre la combinaison du mode de réalisation avec le film de recouvrement de la figure 1 et du mode de réalisation avec la contre-électrode 12 de la figure 3. Ce mode de réalisation permet d'avoir une deuxième barrière de potentiel présente à tout moment et de moduler l'amplitude de cette deuxième barrière de potentiel au moyen de la contre-électrode 12.

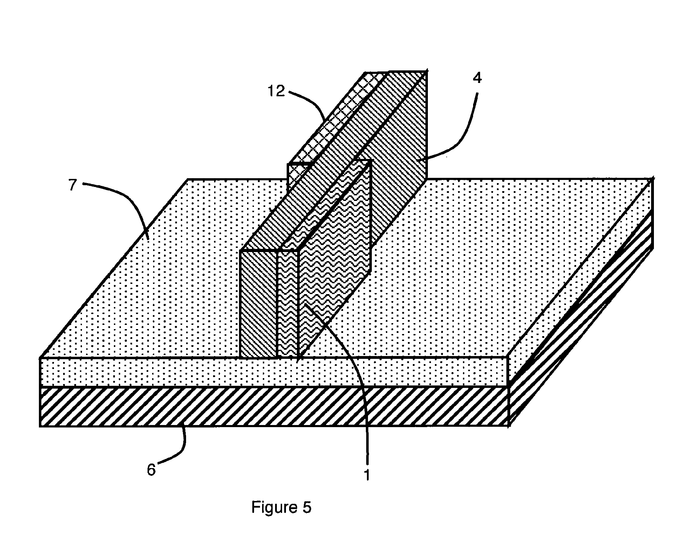

Dans un autre mode de réalisation illustré à la figure 5, le premier dispositif de génération de la première barrière de potentiel Q dans le film semi-conducteur 4 et le deuxième dispositif de génération de la deuxième barrière de potentiel R dans le film semi-conducteur 4 sont disposés de part et d'autre du film semi-conducteur 4.

Le film semi-conducteur 4 est un motif qui fait saillie depuis un film électriquement isolant. Le film électriquement conducteur comporte deux faces principales opposées et au moins une face latérale qui relie les deux faces principales. La face latérale a une interface avec la couche électriquement isolante 7. Le dispositif peut donc être formé sur un substrat de type semi-conducteur sur isolant mais dans une configuration différente de celle représentée à la figure 3. Alors que les modes de réalisation précédents permettaient une co-intégration avec des transistors selon une architecture dite « planaire », ce dernier mode de réalisation permet la co-intégration avec des transistors selon une architecture dite « FinFet ». La différence entre ce type de dispositif et un transistor conventionnel provient du dopage des électrodes de source et drain et dans la surface de recouvrement de l'électrode de grille.

Il est également possible de réaliser le transistor à effet de champ, dans une architecture dite « double grille », par exemple au moyen d'un canal semi-conducteur qui est suspendu ou disposé au-dessus du substrat semi-conducteur. Les deux grilles sont séparées par le film semi-conducteur 4. Dans ce cas de figure, le substrat de type semi-conducteur sur isolant n'est pas obligatoire. Comme pour le mode de réalisation précédent, la différence entre ce type de dispositif et un transistor conventionnel provient du dopage des électrodes de source et drain et dans la surface de recouvrement de l'électrode de grille.

L'électrode de grille 1 est formée sur une des faces principales et le deuxième dispositif de génération de la deuxième barrière de potentiel R est formé sur l'autre face principale. Le deuxième dispositif peut être formé par le film de recouvrement 10 ou, avantageusement, par une deuxième électrode de grille qui fait office de contre-électrode 12. Dans ce mode de réalisation, il existe une grande liberté dans le choix du matériau formant le diélectrique de grille ainsi que dans l'épaisseur formée.

Les modes de réalisation indiqués plus haut et illustrés par exemple aux figures 1 et 2 peuvent être combinés à ce mode de réalisation. Les deux dispositifs de génération des barrières de potentiels peuvent être du même côté du film 4, c'est-à-dire sur la même face principale ou sur des faces principales opposées.

La modulation d'amplitude d'une des deux barrières de potentiel permet de commander la quantité de courant traversant le transistor. La modulation d'amplitude dans les deux barrières permet également d'obtenir cet effet et de définir le passage entre les états bloqué et passant. Le dispositif profite de la rétroaction positive qui existe entre les deux barrières de potentiel. Ainsi, lorsque l'une des barrières de potentiel voit son amplitude diminuer (en valeur absolue), il en va de même pour l'autre barrière de potentiel.

Les première et deuxième barrières de potentiel générées dans le film semi-conducteur empêchent le passage de porteurs de charge entre les première et deuxième électrodes 2 et 3. Dans cette configuration un courant très faible (courant à l'état OFF) circule entre les première et deuxième électrodes, c'est-à-dire un courant parasite.

La modulation de l'amplitude de la première barrière peut être obtenue au moyen du potentiel appliqué sur l'électrode de grille 1 ou au moyen du potentiel appliqué sur la contre-électrode 12 ou par une combinaison de ces deux paramètres.

Il est également envisageable d'avoir une différence de potentiel fixe entre l'électrode de grille 1 et la contre-électrode 12, la modulation de l'amplitude de la barrière étant seulement réalisée au moyen de la contre-électrode 12 dans la zone dépourvue de recouvrement par l'électrode de grille 1. La contre-électrode joue alors le rôle d'électrode de grille qui génère une première barrière de potentiel. Il y a en plus un dispositif de génération d'une deuxième barrière de potentiel qui s'oppose à l'effet électrostatique induit par la contre-électrode 12.

Dans encore une autre variante de réalisation non représentée, l'électrode de grille 1 est disposée à proximité des deux électrodes de source/drain ce qui permet de générer une première barrière de potentiel dans le film 4 entre les deux électrodes 2 et 3. La contre-électrode 12 est disposée à proximité d'une des deux électrodes afin de générer la deuxième barrière de potentiel.

Dans les modes de réalisation particuliers illustrés aux figures 1 à 5, la surface qui sépare la première électrode 2 de source/drain de la deuxième électrode 3 de source/drain n'est pas complètement recouverte par l'électrode de grille 1. Ainsi, dans un axe X qui relie les deux électrodes de source/drain, une partie de la distance parcourue par les porteurs de charge est recouverte par l'électrode de grille 1 et une autre partie est dépourvue de cette couverture de sorte que cette autre partie ne subit pas l'influence électrostatique de l'électrode de grille 1. De cette manière, il existe au-dessus de la zone définie par les électrodes de source et de drain, une portion recouverte par l'électrode de grille 1 et une portion qui est recouverte par un matériau diélectrique dépourvu d'électrode de grille 1 ou une partie qui n'est pas recouverte par un matériau à l'état solide ou liquide. La structure est dite asymétrique car l'électrode de grille 1 n'est pas disposée à équidistance des deux électrodes de source/drain 2 et 3 dans une vue de dessus ou une vue de coupe. Il en est de même lorsque la contre-électrode 12 ne recouvre pas toute la distance inter-électrode ou lorsqu'elle n'est pas disposée à équidistance entre les deux électrodes 2 et 3.

De manière préférentielle, l'électrode de grille 1 est localisée au-dessus de la zone inter-électrode de manière à ce qu'une de ses parois latérales se trouve immédiatement adjacente d'une des deux électrodes de source/drain ou de manière à légèrement recouvrir la première électrode 2. Dans cette configuration, une des parois latérale de l'électrode de grille est alignée avec l'interface entre la première électrode 4 et la zone inter-électrode. Cette configuration particulière permet d'obtenir une bonne compacité du transistor.

L'électrode de grille 1 est donc localisée du coté N du dispositif (c'est-à-dire à proximité immédiate de l'électrode dopée N) ou du coté P du dispositif (c'est-à-dire à proximité immédiate de l'électrode dopée P).

La figure 6 représente l'évolution du potentiel de la bande de valence ou de la bande de conduction à l'intérieur du transistor pour plusieurs conditions de polarisation. La figure 7 représente le courant I_{D} qui circule entre la première électrode 2 et la deuxième électrode 3 en fonction de la différence de potentiel appliquée, par exemple, entre la première électrode 2 et l'électrode de grille 1.

La figure 6 représente la bande de valence ou la bande de conduction dans la première électrode de source/drain 2, dans la première barrière de potentiel Q, dans la deuxième barrière de potentiel R et dans la deuxième électrode de source/drain 3. La figure 6 sera décrite en considérant que le terme bande d'énergie se réfère à la bande de valence ou à la bande de conduction selon le type de porteur considéré. L'exemple illustré correspond à une électrode de grille 1 placée à proximité d'une première électrode 2 dopée de type N. Les valeurs des potentiels sont inversées si la première électrode 2 est dopée de type P.

La différence de potentiel appliquée entre la première électrode de source/drain 2 et la deuxième électrode de source/drain 3 est configurée de manière à passer, en direct, la diode qui existe entre les deux électrodes 2 et 3 ce qui se traduit par un rapprochement des niveaux de potentiel de la bande d'énergie entre la première et la deuxième électrodes. Dans le cas présent, le potentiel appliqué sur la deuxième électrode 3 est supérieur au potentiel appliqué sur la première électrode 2. Dans l'exemple de la figure 6, les niveaux de la bande d'énergie sont identiques pour les deux électrodes de source/drain.

Le potentiel appliqué sur l'électrode de grille 1 génère la première barrière de potentiel Q qui s'oppose à la migration des électrons vers l'électrode 3 de type P. La deuxième barrière de potentiel est de sens opposé et elle s'oppose à la migration de trous d'électrons depuis l'électrode 3 de type P vers l'électrode 2 dopée N. Cette situation est représentée schématiquement par la courbe A.

Dans cette configuration un très faible courant circule entre les deux électrodes de source/drain comme cela est représenté à la figure 7 dans la partie A.

Le potentiel appliqué sur l'électrode de grille 1 évolue de manière à réduire l'amplitude de la première barrière de potentiel Q ce qui entraine une augmentation de la probabilité de passage des charges émises par la première électrode 2 et donc une augmentation légère de la valeur du courant. Les charges émises depuis la première électrode 2 atteignent la seconde électrode 3 ce qui modifie la valeur de l'amplitude de la barrière de potentiel R, cela permet l'émission de charges électriques dans l'autre sens. Cette diminution de l'amplitude des deux barrières de potentiel est représentée par la courbe B.

Comme cela est illustré à la figure 7, dans la partie B, au fur et à mesure de la diminution de la valeur de l'amplitude de la première barrière de potentiel, la valeur du courant I_{D} circulant à l'intérieur du transistor augmente. A partir d'un moment où le potentiel de grille 1 atteint une valeur seuil, les charges électriques émises par la première électrode et passant la première barrière de potentiel Q sont en mesure de créer une chute de potentiel au niveau de la seconde électrode 3 ce qui induit une diminution rapide de l'amplitude de la deuxième barrière de potentiel R et un courant important depuis la deuxième électrode 3 vers la première électrode 2. Les deux courants de charges électriques entrainent chacun une diminution des deux barrières de potentiel de sorte qu'un courant important se met à circuler brusquement à l'intérieur du transistor comme cela est représenté dans la zone C de la figure 7.

Comme cela est visible sur la figure 6, lors du passage du courant dans le transistor à l'état passant, les barrières de potentiel Q et R sont réduites en amplitude.

Des mesures électriques ont été réalisées sur un dispositif et le courant parasite mesuré à l'état bloqué est inférieur ou égal à 10-¹¹A/µm (régime A). Le courant circulant à l'état passant (régime C) évolue entre 10⁻⁸ et 10⁻³ A/µm selon les conditions de polarisations de la diode. La pente sous le seuil de cette architecture particulière est très inférieure à ce qui est mesuré classiquement pour les transistors conventionnels. Les simulations numériques montrent que le dispositif à double barrière de potentiel peut être miniaturisé jusqu'à au moins une longueur de zone inter-électrode égale à 30nm et avec une épaisseur de film 4 égale à 10nm. La tension de polarisation aux bornes du transistor est égale ou de l'ordre de 1 V.

Par ailleurs, le transistor fonctionne avec la diode en polarisation directe et avec une maitrise du flux de porteurs de charge au moyen de deux barrières de potentiel de sens opposés. Dans son utilisation, le transistor n'utilise pas un fonctionnement par ionisation par impact ou un fonctionnement pas effet tunnel, deux phénomènes qui sont néfastes pour une bonne tenue dans le temps des performances du dispositif.

Le transistor obtenu, est donc un transistor sans ionisation par impact et avec une pente sous le seuil extrêmement réduite qui porte la dénomination Z²FET pour « zero impact ionization and zero swing Field Effect Transistor ».

## Revendications

1. Transistor à effet de champ comportant :
- une première électrode de source/drain (2) formée dans un film en matériau semi-conducteur (4) par une première zone dopée de type N,
- une deuxième électrode de source/drain (3) formée dans le film en matériau semi-conducteur (4) par une deuxième zone dopée de type P,
- une zone inter-électrode formée dans le film en matériau semi-conducteur (4) et séparant les deux électrodes de source/drain (2, 3),
- une électrode de grille (1, 12) recouvrant partiellement la zone inter-électrode,
- un circuit d'application d'une première différence de potentiel entre la première électrode de source/drain (2) et la deuxième électrode de source/drain (3) configuré pour polariser l'électrode dopée de type P à un potentiel supérieur à celui de l'électrode dopée de type N,
- un premier dispositif de génération d'une première barrière de potentiel (Q) dans le film semi-conducteur (4), la première barrière de potentiel (Q) s'opposant au passage de porteurs de charge émis par la première électrode de source/drain (2),
- un deuxième dispositif de génération d'une deuxième barrière de potentiel (R) dans le film semi-conducteur (4), la deuxième barrière de potentiel (R) s'opposant au passage de porteurs de charge émis par la deuxième électrode de source/drain (3), la deuxième barrière de potentiel (R) étant décalée de la première barrière de potentiel (Q) selon un axe (X) reliant les deux électrodes de source/drain (2, 3),
transistor **caractérisé en ce que** l'un des dispositifs de génération de barrière de potentiel (Q, R) est configuré pour générer une barrière de potentiel à amplitude modulable et est relié électriquement à l'électrode de grille (1, 12), l'autre des dispositifs de génération de barrière de potentiel (Q, R) est reliée électriquement à une contre-électrode (12, 1) séparée de l'électrode de grille (1, 12) par le film en matériau semi-conducteur (4).

2. Transistor selon la revendication 1, dans lequel le film semi-conducteur (4) est séparé d'un substrat de support (6) par un film électriquement isolant (7), l'électrode de grille (1) étant séparée du substrat de support (6) par le film électriquement isolant (7).

3. Transistor selon la revendication 2, dans lequel le film semi-conducteur (4) forme un motif en saillie sur le film électriquement isolant (7), le motif en saillie comporte deux faces principales opposées reliée par une face latérale ayant une interface avant le film électriquement isolant (7), l'électrode de grille (1) étant disposée sur une des faces principales.

4. Transistor selon l'une quelconque des revendications 1 à 3, dans lequel l'autre des dispositifs de génération de barrière de potentiel (Q, R) comporte un film isolant de recouvrement (10) configuré de manière à présenter des charges électriques à l'interface entre le film isolant de recouvrement (10) et le film semi-conducteur (4) ou dans le film isolant de recouvrement (10).

5. Transistor selon la revendication 4, dans lequel l'autre des dispositifs de génération de barrières de potentiel (Q, R) comporte une zone dopée additionnelle formée dans le film en matériau semi-conducteur (4) et faisant face au film isolant de recouvrement (10), la zone dopée additionnelle formant une jonction PN ou NP à l'interface avec une des deux électrodes de source/drain (2, 3).

6. Transistor selon l'une quelconque des revendications 1 à 5, dans lequel la contre-électrode (12, 1) recouvre toute la surface inter-électrode.

7. Transistor selon l'une quelconque des revendications 1 à 6, comportant un circuit de polarisation de l'électrode de grille (1) configuré pour appliquer une différence de potentiel entre la première électrode de source/drain (2) et l'électrode de grille (1) qui est de même signe que la différence de potentiel entre la première électrode de source/drain (2) et la deuxième électrode de source/drain (3).
